Europäisches Patentamt

European Patent Office

Office européen des brevets

(11) Publication number: **0 227 373 B1**

# EUROPEAN PATENT SPECIFICATION

(45) Date of publication of patent specification: **05.08.92**  (51) Int. Cl.[5]: **H01L 21/263**

(21) Application number: **86309574.1**

(22) Date of filing: **09.12.86**

(54) Process for fabricating a semiconductor structure.

(30) Priority: **16.12.85 JP 280934/85**

(43) Date of publication of application:
**01.07.87 Bulletin 87/27**

(45) Publication of the grant of the patent:
**05.08.92 Bulletin 92/32**

(84) Designated Contracting States:
**DE FR GB**

(56) References cited:

**PATENT ABSTRACTS OF JAPAN vol.4 no.152
(E-31)(634), 24th October 1980; & JP-A-55 103
718**

**PATENT ABSTRACTS OF JAPAN vol. 9 no.
225 (E-343)(1948), 11th September 1985; &
JP-A-60 81829**

**PATENT ABSTRACTS OF JAPAN vol. 9 no. 99
(E-311)(1822), 27th April 1985; & JP-A-59 225
584**

**JOURNAL OF APPLIED PHYSICS vol.55, no.
12, (1984) June, pages 4430-4435, New York,
US; H.G. CRAIGHEAD: "10-nm resolution
electron-beam lithography".**

**APPLIED PHYSICS LETTERS vol. 41, no. 7,
(1982) October, pages 635-638, New York,
US; P.M. PETROFF et al.: "Toward quantum
well wires: Fabrication and optical proper-
ties."**

(73) Proprietor: **HITACHI, LTD.
6, Kanda Surugadai 4-chome
Chiyoda-ku, Tokyo 101(JP)**

(72) Inventor: **Fukuzawa, Tadashi
3-23-2, Kyodo
Setagaya-ku Tokyo(JP)**
Inventor: **Chinone, Naoki
Tamagawa Juutaku Ro-12-403
Somechi Chofu-shi Tokyo(JP)**
Inventor: **Tonomura, Akira
1-1-10, Nukuiminami-cho
Koganei-shi Tokyo(JP)**

(74) Representative: **Calderbank, Thomas Roger et
al
MEWBURN ELLIS & CO. 2/3 Cursitor Street
London EC4A 1BO(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a process for fabricating a semiconductor structure.

It has been known theoretically that semiconductor lasers which exploit the quantum size effect based on a multi-dimensional quantum well structure have characteristics superior to those of conventional quantum well lasers (Y. Arakawa and H. Sakaki, Appl. Phys. Lett., Vol. 40, No. 11, (1982) p. 939).

To substantiate this, attempts have been made to photoetch a superlattice and fabricate a quantum wire which is triangular in cross section (P.M. Petroff et al, Appl. Phys. Lett., Vol. 41, October 1982, p. 635). In addition, a metal wire which is 10 nm wide has been obtained with electron-beam lithography (H.G. Graighead et al, Appl. Phys. Lett., Vol. 42, January 1983, p. 38).

A multiple quantum wire which is sufficiently ultrafine to produce the quantum size effect and which has wire characteristics whose widths, straightness and inter-wire distances are sufficiently uniform is highly desirable in the further development of semiconductor lasers and electronic devices. Therefore there is a strong desire to develop a process for fabricating quantum wires which is easy and which is of high reliability.

The prior arts mentioned above do not permit of industrial production, and thus the fabrication technology to form multiple quantum wires having uniform wire widths, straightness and inter-wire distances has not yet been established.

JP-A-60-81829 discloses a method for fabricating concave and convex structures in a semiconductor substrate by using interference strips of He-Cd laser beams however the wavelength of a HE-Cd laser is too long to provide any ultra-fine pattern for quantum wires or quantum boxes.

JP-A-55-103718 discloses an apparatus for generating electron beam interference pattern, which apparatus can be used to obtain a single crystal thin film.

The present invention provides a process for fabricating a semiconductor structure having a plurality of quantum wires or quantum boxes; the process comprising:

forming semiconductor and/or mask layers on a semiconductor substrate;

forming an electron beam resist film on the outer one of said semiconductor and/or mask layers;

irradiating the film by interfering coherent electron beams, thereby to form a periodic photoresist pattern in the film;

processing the film, to shape it to the exposure pattern; and

transferring that exposure pattern to at least the outer layer.

Once the resist layer has been suitably exposed, it may be developed by conventional techniques and then used as a mask for e.g. ion implantation and/or etching of layers below the mask. Thus by transferring the resulting pattern to e.g. an active layer of a semiconductor laser, very fine patterns may be formed in that active layer.

It has been found that, by using the present invention to produce semiconductor devices such devices are much more efficient than known devices. For example if the active region of a semiconductor laser has dimensions of 50 nm or less, so giving a quantum size effect, the threshold current of the laser can be reduced to less than 1/10 of the current for known devices, i.e. less than 1 mA. This also makes possible the omission of components for correcting the threshold current. Similarly, if the control region of a transistor has dimensions of 50 nm or less, the operating frequency may then be greater than 100 GHz. More generally, it has been found possible to fabricate quantum wires and quantum boxes in which the smallest dimension of the wires or boxes are 3 to 50 nm. Indeed the present invention permits quantum wires or boxes with cross-sectional dimensions of 10 nm $\times$ 10 nm or less.

Furthermore, the use of coherent electron beams permits the accurate formation of a periodic pattern and, since the periodic pattern may be determined by the cross-angle of the interferring beams, this permits the pattern to be formed in the resist layer more rapidly than with known electron beam techniques. The use of a periodic pattern permits quantum wire widths, straightness and inter-wire distance to be made uniform reliably and accurately, and this improves the performance of electronic devices, e.g. semiconductor lasers, transistors, bistable devices, produced by the present invention.

Embodiments of the invention will now be described in detail, by way of example, with reference to the accompanying drawings, in which:

Figs. 1 - 4 are sectional views of semiconductor structures showing a process in which quantum wires are fabricated by crystal mixing of a micro heterostructure based on electron holography and ion implantation

Fig. 5 shows a schematic view of a quantum wire laser;

Fig. 6 is a schematic view showing an experiment for verifying the fabrication of the quantum wires;

Fig. 7 is a cross-sectional view of a semiconductor laser;

Fig. 8 is a perspective view of a structure which has quantum boxes;

Fig. 9 is a cross-sectional view of a permeable base transistor being an example of a device produced by the present invention;

Figs. 10 and 11 are diagrams for explaining a bistable device being another example of a device produced by the present invention.

Example 1

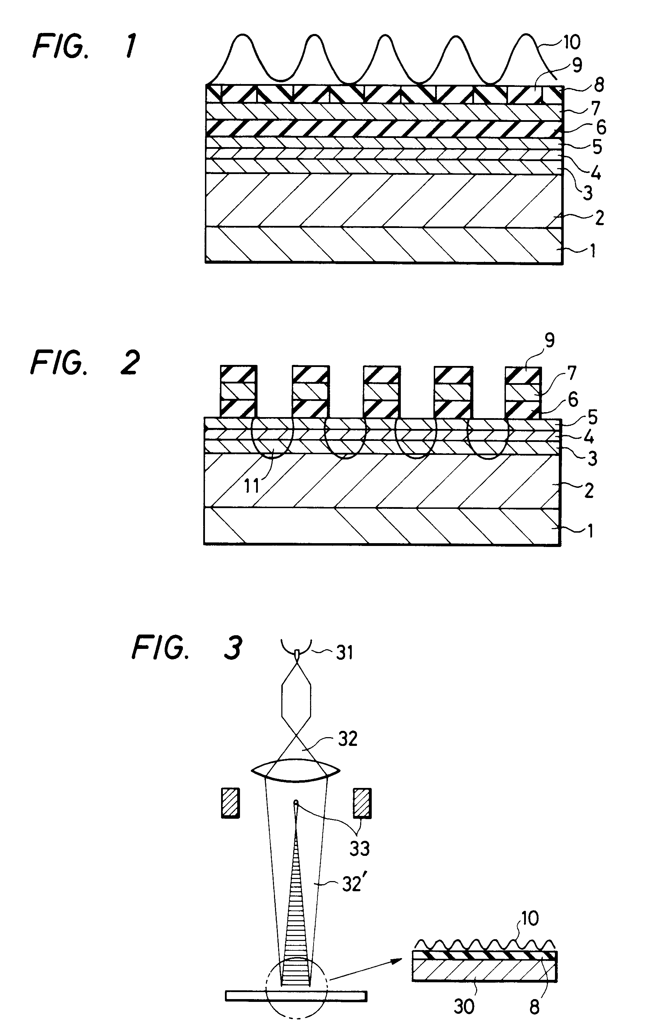

This example will be described with reference to Figs. 1 to 6.

Fig. 1 shows a semiconductor crystal coated with a multilayer resist which was placed in an electron-beam lithography system.

An n-$Ga_{0.5}Al_{0.5}As$ cladding layer 2 (2 $\mu$m thick), an n-$Ga_{0.6}Al_{0.4}As$ barrier layer 3 (10 nm thick), an undoped GaAs quantum well layer (superlattice layer) 4 (10 nm thick) and a p-$Ga_{0.4}Al_{0.6}As$ barrier layer 5 (10 nm thick) were successively grown on an n-GaAs substrate 1 by the known method of molecular beam epitaxy. Thereafter, an electron-beam resist layer 6, a Ge-evaporated thin film 7 (20 nm thick) and an electron-beam resist layer 8 (50 nm thick) were formed by known methods. Examples of suitable methods for depositing the resist layers include spin coating and spray coating.

Subsequently, as shown in Fig. 3, beams 32' obtained by dividing into two a highly coherent electron beam (at an acceleration voltage of 50 keV) 32 emergent from an electron beam source 31. The beams 32' were divided into two by means of an electron biprism 33, and were superposedly projected on the semiconductor 30 described above. This generated a standing wave 10 of electron density distribution on the resist 8 as illustrated in Fig. 1. This electron density distribution caused regions 9 of the electron beam resist 8 to be intensely exposed to the electron beam, and the repetition period of the regions 9 was 20 nm.

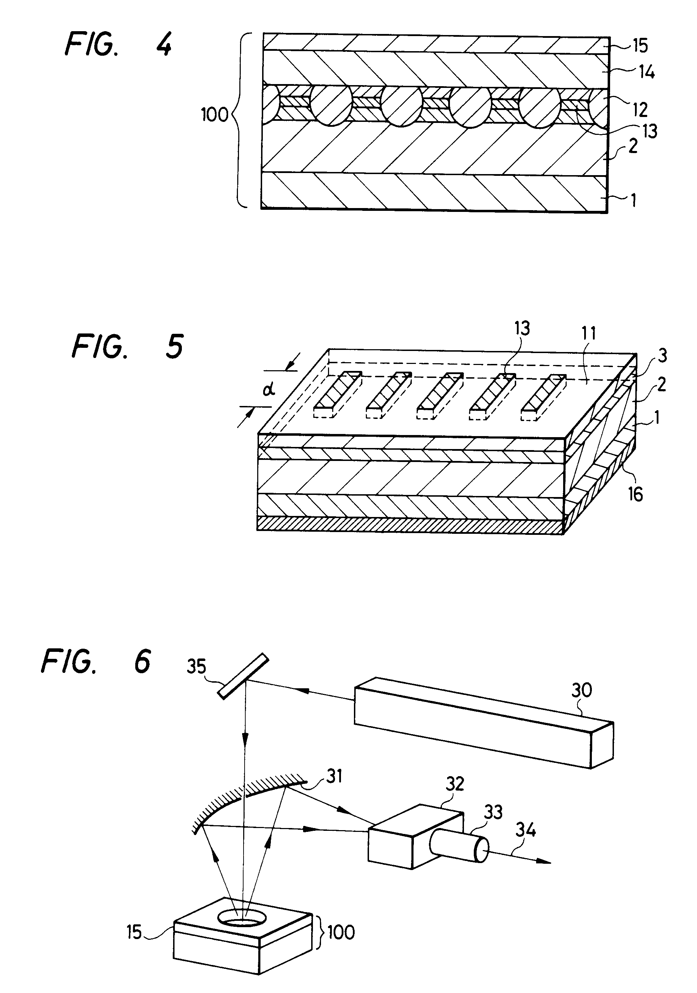

After being exposed to the electron beam at a current density of $3 \times 10^{-5}$ A/cm$^2$ for 10 seconds, the parts of the resist 8 other than the regions 9 were removed by a development employing a conventional method. Subsequently, plasma etching which employed CF$_4$ was used to etch the Ge layer 7 and to etch the resist layer 6 (as shown in Fig. 2). Using the resultant ultrafine pattern of the multi-layer resist, Ga ions were implanted at an acceleration voltage of 50 keV so as to form regions 11 of high Ga concentration. After removing the layers 6,7 and 9, a p-$Ga_{0.5}Al_{0.5}As$ cladding layer 14 (2 $\mu$m thick) and a p-GaAs cap layer 15 (0.2 $\mu$m thick) were grown in a molecular-beam epitaxy apparatus. The resultant structure was then annealed at 850°C in an As atmosphere for 2 hours, to change the layers 3, 4 and 5 within the regions 11 into a mixed crystal by virtue of the impurity induced disordering (refer to Fig. 4).

As a result, the remaining parts of the GaAs layer 4 were buried in the mixed crystal 12 together with the layers 3 and 5, the band gaps of which were greater than that of GaAs. Thus, those parts of the GaAs layer became quantum wires 13 each being 10 nm thick and 12.5 nm wide. This completed the semiconductor structure 100. Subsequently as shown in Fig. 6, the cap layer 15 of the structure 100 was partly removed, and the structure was excited with an Ar laser 30 to measure the photo luminescence spectrum. In Fig. 6 there is shown an apertured parabolic mirror 31, a monochrometer 32, a photodetector 33, an electric signal output 34, and a reflector 35. The emission wavelength of the semiconductor structure was 815 nm, which was shorter than the oscillation wavelength 840 nm of a semiconductor laser employing an ordinary superlattice 10 nm thick. Thus, it was verified that quantum wires were formed.

Example 2

An example in which a semiconductor laser was constructed using the semiconductor structure discussed in Example 1 will be described with reference to Figs. 2, 4, 5 and 7.

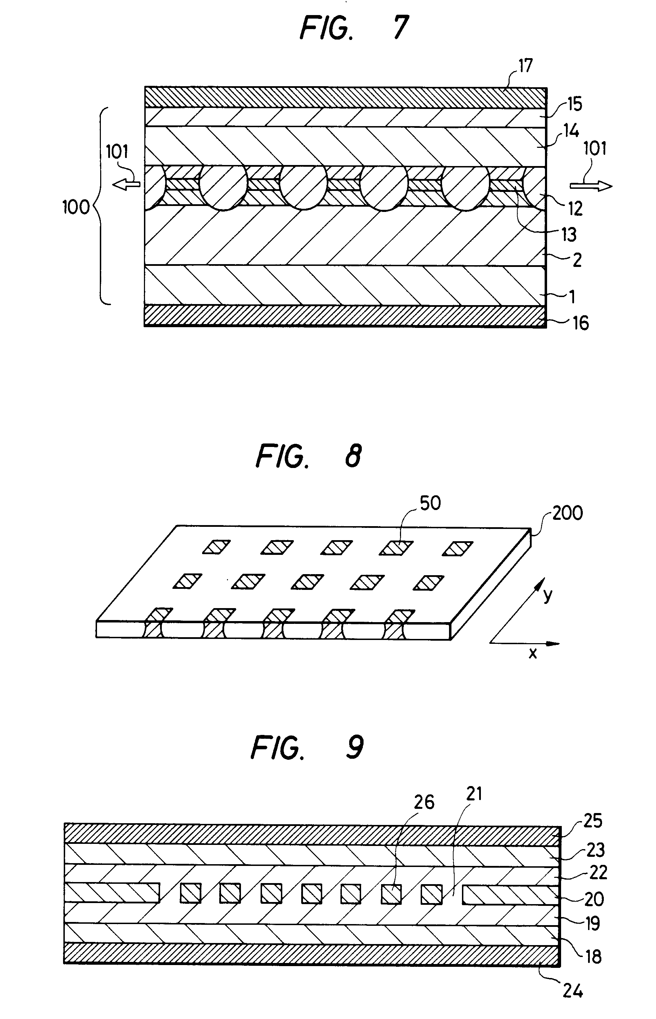

A structure similar to that shown in Fig. 4 was prepared by the same method as discussed in Example 1. 5000 quantum wires were formed in an array extending in the resonator direction of the laser. The length of the quantum wires in a direction perpendicular to the resonator direction of the laser was 1 $\mu$m. This length was determined by processing such that, after holographic exposure, the lengths of the quantum wires were limited to 1$\mu$m by conventional electron-beam lithography. The cross-section of the crystal parallel to the laser resonator direction was the same as depicted in Fig. 4. Thereafter, as illustrated in Fig. 7, an n-side electrode 16 and a p-side electrode 17 were formed on the structure 100 of Fig. 4, and the result was cleaved by a conventional method, thereby to complete the laser device. The direction of emission of the laser radiation is shown by arrow 101. Fig. 5 shows the cut model of this laser device in a plane parallel to the quantum wires.

With a quantum wire laser having a laser resonator length of 100 $\mu$m and a stripe width of 1 $\mu$m, the oscillating threshold current was found to be 1 mA, and the oscillating wavelength was found to be 810 nm.

Example 3

In Examples 1 and 2, Ga ions were implanted, and the micro-fabricated heterostructure was subjected to the crystal mixing operation. In this third example Si ions were implanted for crystal mixing, thereby to fabricate a quantum wire laser in which the dimensions of quantum wires were 10 nm × 20 nm. The characteristics of this laser were a threshold current of 2 mA and an oscillation wavelength of 835 nm.

Example 4

In this example, after the end of the electron-beam holographic exposure in Example 1, the sample was rotated by 90° and was again subjected to holographic exposure employing electron beams, and it was developed. This resulted in resist patterns with a square shape each square being 15 nm × 15 nm. Thereafter, the crystal was processed by the same method as in Example 1, thereby to obtain a semiconductor structure 200 having generally cubic quantum boxes 50, each one of which was 10 nm, as shown in Fig. 8.

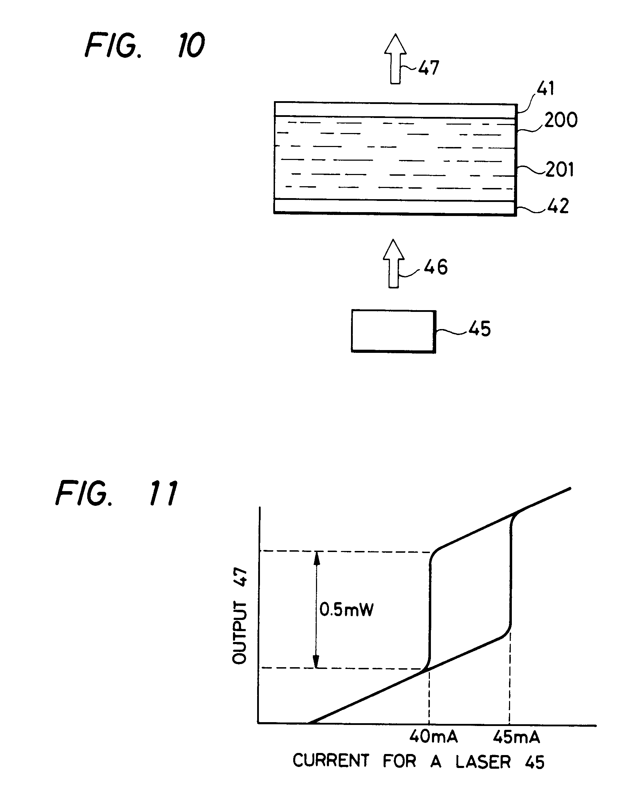

This structure was utilized to manufacture a bistable device. As shown in Fig. 10, structures 200, each having quantum boxes were stacked in a multiplicity of layers to form a layered structure 201. Known dielectric multilayer films 41 and 42, each consisted of a stack of an $SiO_2$ film and an $Si_3N_4$ film, were formed as mirrors (reflection factor: 90%) on the surfaces of the laminated structure 20l. Thus, the bistable device 202 was completed. A beam 46, of a wavelength of 810 nm from a semiconductor laser 45 was applied to this device, and the relationship between the input beam and an output beam 47 from the device 202 was investigated. The result was a bistable characteristic as shown in Fig. 11. The response rate of this characteristic was 20 GHz.

Example 5

This example will be described with reference to Fig. 9.

Using the micro fabrication process based on electron holography, a permeable base transistor (PBT) as shown in Fig. 9 was manufactured. After an n-GaAs layer 19 was grown on an n-GaAs crystal substrate 18, a tungsten film 20 was evaporated to a thickness of 30 nm. Thereafter, the tungsten film was coated with an electron-beam resist, an electron-beam resist grating having a period of 50 nm and a width of 30 nm was prepared by electron holography, and window regions 21 were provided in the tungsten layer by dry etching. Thus, quantum wires were formed.

After the resist was removed, an undoped GaAs layer 22 was grown by e.g. a MOCVD process so as to fill up the regions 21 lacking in tungsten. Subsequently, an n-GaAs layer 23 was grown, and ohmic electrodes 24 and 25 were formed. The tungsten electrode 20 was connected to the exterior by providing holes in parts of the electrode 25 and the crystals 22,23 and was used as a control (base) electrode. The current - voltage characteristic of the transistor was a triode characteristic, and the modulation frequency was 100 GHz.

In the examples thus far described, the fluctuations of the periods of the quantum wires were found to be within ±0.2%.

Also quantum wires and quantum boxes whose patterns had periods of 3 nm could be fabricated by the same methods as in the foregoing examples, and the fluctuations of the periods were within ±0.4%.

Thus, according to the present invention, it becomes possible to produce semiconductor structures, and hence electronic devices, with sub-micron patterns, thereby improving the operation of such devices. In consequence apparatuses utilizing such devices are enhanced, and the design of such apparatuses is facilitated, and they may be produced at reduced cost, particularly due to the decrease in the number of components and the reduction in power consumption.

**Claims**

1. A process for fabricating a semiconductor structure having a plurality of quantum wires (13) or quantum boxes (50); the process comprising:
   forming semiconductor and/or mask layers (2,3,4,5,6,7) on a semiconductor substrate (1);
   forming an electron beam resist film (8) on the outer one (7) of said semiconductor and/or mask layers;
   irradiating the film (8) by interfering coherent electron beams, thereby to form a periodic photoresist pattern in the film (8);
   processing the film (8), to shape it to the exposure pattern; and
   transferring that exposure pattern to at least the outer layer (7).

2. A process according to claim 1 wherein the exposure pattern is also transferred to at least one layer (6) other than the outer layer (7).

3. A process according to claim 1 or claim 2, wherein the transfer of the exposure pattern includes ion implantation (11) into parts of at least some of the layers (2,3,4,5).

4. A process according to claim 3, wherein the ion implanted is Ga.

5. A process according to anyone of the preceding claims wherein one of the dimensions of the periodic pattern is 3 to 50 nm.

6. A process according to any one of the preceding claims, wherein the pattern is a holographic pattern.

7. A process according to any one of claims 3 to 6, wherein the quantum wires (13) or boxes (50) are define by regions of one (4) of the layers into which ions were implanted, those regions being other than the parts of the one layer (4) in which ions were implanted.

8. A process according to any one of the preceding claims, wherein the semiconductor structure is a transistor or a semiconductor laser.

**Revendications**

1. Procédé pour fabriquer une structure semiconductrice possédant une pluralité de fils de stockage de quanta (13) ou de logements de stockage de quanta (50); le procédé consistant à :

   former des couches semiconductrices et/ou des couches de masquage (2,3,4,5,6,7) sur un substrat semiconducteur (1);

   former une pellicule de vernis (8) sensible à un faisceau d'électrons, sur l'une (7) desdites couches semiconductrices et/ou desdites couches de masquage;

   irradier la pellicule (8) au moyen de faisceaux d'électrons cohérents interférant entre eux de manière à former un motif périodique de vernis photosensible dans la pellicule (8);

   traiter la pellicule (8) de manière à lui donner la forme du motif d'exposition; et

   transférer ce motif d'exposition au moins à la couche extérieure (7).

2. Procédé selon la revendication 1, selon lequel le motif d'exposition est également transféré à au moins une couche (6) autre que la couche extérieure (7).

3. Procédé selon la revendication 1 ou 2, selon lequel le transfert du motif d'exposition inclut une implantation ionique (11) dans des parties d'au moins certaines des couches (2,3,4,5).

4. Procédé selon la revendication 3, selon lequel l'ion implanté est du Ga.

5. Procédé selon l'une quelconque des revendications précédentes, selon lequel l'une des dimensions du motif périodique est comprise entre 3 et 50 nm.

6. Procédé selon l'une quelconque des revendications précédentes, selon lequel le motif est un motif holographique.

7. Procédé selon l'une quelconque des revendications 3 à 6, selon lequel les fils (13) ou les logements (50) de stockage de quanta sont définis par des régions de l'une (4) des couches, dans laquelle des ions ont été implantés, ces régions étant autres que les parties de la couche (4) dans laquelle des ions ont été implantés.

8. Procédé selon l'une quelconque des revendications précédentes, selon lequel la structure semiconductrice est un transistor ou un laser à semiconducteurs.

**Patentansprüche**

1. Verfahren zur Herstellung einer Halbleiterstruktur mit einer Vielzahl von Quantenfäden (13) oder Quantenzellen (50), umfassend:

   Bilden von Halbleiter- und/oder Maskenlagen (2, 3, 4, 5, 6, 7) auf einem Halbleitersubstrat (1),

   Bilden eines Elektronenstrahl-Resistfilms (8) auf der äußeren (7) der genannten Halbleiter- und/oder Maskenlagen,

   Bestrahlen des Films (8) mittels interferierender, cohärenter Elektronenstrahlen, um dadurch ein periodisches Photoresist-Muster in dem Film (8) zu bilden,

   Entwickeln des Films (8) um ihm die Form des Belichtungsmusters zu geben, und

   Übertragen des Belichtungsmusters auf mindestens die äußere Lage (7).

2. Verfahren nach Anspruch 1, wobei das Belichtungsmuster außerdem auf mindestens eine von der äußeren Lage (7) verschiedene Lage (6) übertragen wird.

3. Verfahren nach Anspruch 1 oder 2, wobei das Übertragen des Belichtungsmusters eine Ionenimplantation (11) in Teile mindestens einiger der Lagen (2, 3, 4, 5) beinhaltet.

4. Verfahren nach Anspruch 3, wobei die implantierten Ionen Ga sind.

5. Verfahren nach einem der vorhergehenden Ansprüche, wobei eine der Dimensionen des periodischen Musters 3 bis 50 nm beträgt.

6. Verfahren nach einem der vorhergehenden Ansprüche, wobei das Muster ein holographisches Muster ist.

7. Verfahren nach einem der Ansprüche 3 bis 6, wobei die Quantenfäden (13) oder Zellen (50) durch Gebiete einer (4) der Lagen, in die Ionen implantiert wurden, definiert sind, wobei diese Gebiete von den Teilen der einen Lage (4), in die Ionen implantiert wurden, verschieden sind.

8. Verfahren nach einem der vorhergehenden Ansprüche, wobei die Halbleiterstruktur ein Transistor oder ein Halbleiterlaser ist.

FIG. 1

FIG. 2

FIG. 3

FIG. 4

FIG. 5

FIG. 6

EP 0 227 373 B1

FIG. 7

FIG. 8

FIG. 9

FIG. 10

FIG. 11